# EUROPEAN PATENT SPECIFICATION

(11) **EP 0 944 557 B1**
(45) Date of publication and mention of the grant of the patent: **06.11.2002**
(21) Application number: 97936780.2
(22) Date of filing: 12.08.1997
(51) Int. Cl.: C03C 17/00, C03C 17/245, C23C 16/40

(54) **METHOD OF DEPOSITING TIN OXIDE AND TITANIUM OXIDE COATINGS ON FLAT GLASS AND THE RESULTING COATED GLASS**
VERFAHREN ZUR ABSCHEIDUNG VON BESCHICHTUNGEN AUS ZINNOXID UND TITANOXID AUF FLACHGLAS UND SO BESCHICHTETES GLAS
PROCEDE SERVANT A DEPOSER DE L'OXYDE D'ETAIN ET DE L'OXYDE DE TITANE SUR UNE PLAQUE DE VERRE ET VERRE REVETU AU MOYEN DE CE PROCEDE

(30) Priority: 13.08.1996 GB 9616983
(43) Date of publication of application: 29.09.1999
(60) Divisional application: 02008475.2
(73) Proprietor: PILKINGTON PLC, St. Helens, Merseyside WA10 3TT (GB); LIBBEY-OWENS-FORD CO., Toledo, OH 43695 (US)
(72) Inventor: SHEEL, David, William, Lancashire L39 5EB (GB); McCURDY, Richard, J., Toledo, OH 43606 (US); HURST, Simon, James, Cheshire WA7 1QW (GB)
(74) Representative: Halliwell, Anthony Charles
(86) International application number: GB9702179
(87) International publication number: WO98006675

(56) References cited:
- EP-A- 0 186 481
- GB-A- 2 044 137
- US-A- 4 731 256
- US-A- 5 124 180
- US-A- 5 401 305
- DATABASE WPI Section Ch, Week 9717 Derwent Publications Ltd., London, GB; Class L01, AN 97-180109 XP002047099 & CN 1 093 067 A (UNIV SHANDONG) , 5 October 1994

## Description

### BACKGROUND OF THE INVENTION

### 1. Field of the Invention

This invention relates to a process for depositing titanium oxide coatings on a flat glass substrate, and the resulting coated glass. More particularly, this invention relates to a chemical vapour deposition process for producing titanium oxide coatings on flat glass using a coating precursor gas mixture comprising titanium tetrachloride and an organic oxidant.

### 2. Summary of Related Art

Titanium oxide coatings have been proposed for use on glass containers, for example bottles, to improve the mechanical strength of the containers. It has also been proposed to use titanium oxide coatings on flat glass to modify the characteristics of the glass for architectural use; titanium oxide coatings deposited under vacuum (by reactive sputtering) are used as components of sputtered multi-layer infra red reflecting coatings.

GB patent specification 1 115 342 describes a process for producing glass containers with good inherent strength and good abrasion resistance by spraying the containers, while still hot from the manufacturing process, with a solution or dispersion of stannic chloride (that is, tin tetrachloride) in an organic liquid, isopropyl alcohol being preferred. A small amount of titanium chloride may be incorporated as a modifier. The liquid solution is fed to atomisers, which may be of the pressure jet variety, located on either side of a tunnel over a conveyor for hot glass bottles to produce a 'mist of liquid reagent' so that a layer of liquid is formed on all the external surfaces of the bottles where it reacts to form a layer of tin oxide.

GB patent specification 1 187 784 describes an improvement of the process described in GB patent specification 1 115 342 and apparently more suitable for incorporation into a process for the automatic manufacture of glassware without interfering with the normal running of such process and without requiring additional supervision. The specification proposes to treat glass containers, at high temperature, with a liquid solution of an organic compound of tin "which compound has properties such that upon application of heat it decomposes into two materials, one of which is an organic compound of tin of high decomposition temperature which reacts with the glass surface to produce a diffusion layer of tin oxide within the glass surface, while the other is a volatile compound of tin such that a substantial proportion of vapour of said compound is produced, and subjecting the containers to a heat treatment such that a reaction is caused to occur between the glass at at least the surfaces of the containers and the tin compounds". The material used for treating the glass containers may be provided by reacting tin tetrachloride with organic substances containing carbonyl groups of moderate activity e.g. organic esters of ethyl, n-propyl, isopropyl, n-butyl and isobutyl alcohols with acetic, propionic and butyric acids. The resulting solution may be sprayed, in the presence of ambient atmosphere, on to the hot containers e.g. in the form of a fine mist after they leave the forming machine and before they enter the annealing lehr. GB patent specification 1 187 783 describes an analogous process to that described in 1 187 784 in which an organic compound of titanium is sprayed on to the hot glass containers in place of the organic compound of tin. The organic titanium compound may be produced, in an analogous manner to the organic compound of tin, by reacting titanium tetrachloride with an organic ester e.g. n-butyl acetate. Again, the resulting solution is sprayed onto the glass in the ambient atmosphere on the container production line.

Processes involving use of the reactants in gaseous form (also called CVD or chemical vapour deposition processes) have certain advantages over spray processes for coating flat glass, especially when the reactants can be premixed before application to the glass. Unfortunately, tin tetrachloride reacts readily with water so that previous proposals to use tin tetrachloride and water vapour in gaseous form have usually involved supplying the gases separately to the glass surface and mixing them while in contact with the glass.

GB patent specification 2 044 137A relates to such a process in which discrete laminar streams of each reactant are formed and projected on to a hot glass substrate by bringing the streams together in reciprocal tangential contact over the glass. Titanium tetrachloride may be used as one of the gaseous reactants, in place of the tin tetrachloride, in order to form a titanium oxide coating. The patent also suggests supplying hydrogen to one of the gas streams to attenuate the violent reaction between the tin tetrachloride and the water vapour. This may be done either by direct addition of gaseous hydrogen, or by the addition of methanol, which is said to react in situ to produce the desired gaseous hydrogen.

European patent specifications 0 365 239B1 and 0 376 240B1 describe a method and apparatus for depositing a tin oxide coating on a hot glass ribbon. A first gaseous stream of tin tetrachloride in preheated dry air is caused to flow along the surface of the hot ribbon of glass advancing beneath a coating chamber, a second turbulent stream of hydrofluoric acid and steam introduced into the coating chambers at right angles to the plane of the glass and direction of flow of the first gaseous stream, and the combined first and second gas streams drawn through the coating chamber over the glass under turbulent flow conditions. The method and apparatus may also be used to apply a coating of titanium oxide using titanium tetrachloride in place of the tin tetrachloride.

US patent 4 590 096 describes a process in which a coating solution comprising a substantially solvent free mixture of an organotin chloride and a reactive organic fluorine compound soluble in or miscible with the organotin chloride is introduced to a preheated carrier gas stream which contains sufficient water vapour that the relative humidity of the gas stream at 18°C is about 6% to about 100%. The resulting gas stream is passed over a hot glass surface to deposit a fluorine doped tin oxide coating on the hot glass. A wide range of organotin compounds may be used, and the possibility of using tin tetrachloride is mentioned. Similarly, a wide range of organic fluorine compounds, including oxygen containing compounds, for example trifluoroacetic acid and ethyltrifluoroacetate, may be used. Some of the fluorine-containing dopants have limited solubilities in the organotin compounds used, and an optional solubiliser may be used to increase the solubility of the fluorine dopant on the organotin compound; acetic anhydride, ethyl acetate, hexane, methyl isobutyl ketone and butyraldehyde are listed as non-limiting examples of the solubilisers that may be used. However, the US patent, in common with the other patents utilising chemical vapour deposition methods to deposit a metal oxide from a gaseous metal tetrachloride, utilises water vapour as the source of oxygen.

US patent 4 751 149 Vijaykurnar et al is concerned with deposition of zinc oxide coatings by chemical vapour deposition at low temperature (60° to 350°C, preferably 100° to 200°C) on heat sensitive photoconductor substrates, and proposes to deposit the zinc oxide coatings from an organozinc compound and an oxidant, which may be an oxygen containing organic compound e.g. an ester, and an inert carrier gas. Although the patent is not entirely clear, it apparently proposes to introduce separate streams of the organozinc compound and oxidant into the deposition chamber, and certainly there is no proposal to pre-mix these components together before delivery to the coating chamber.

EP 0 186 481 relates to tin oxide coatings, US 5 401 305 relates to coatings on substrates, US 4 731 256 relates to fluorine-doped tin oxide coatings and US 5 124 180 relates to fluorine containing metal oxide coatings on substrates.

It would be advantageous to provide a method for depositing titanium oxide coatings by a CVD process applied to hot flat glass using a premixture of titanium tetrachloride as a low cost reactant and a source of oxygen without premature reaction between the metal tetrachloride and oxygen source (previously water) resulting in formation of metal oxide in the coating equipment with consequent problems and inefficiency. It would be particularly advantageous if the method allowed for deposition of the coating at high rates, enabling a required coating thickness to be deposited on a moving glass ribbon during the glass production process.

### SUMMARY OF THE INVENTION

In accordance with the present invention, there is provided a chemical vapour deposition process for laying down a titanium oxide coating on a hot glass substrate using a precursor gas mixture containing titanium tetrachloride and an organic source of oxygen, without the requirement for inclusion of water vapour and the consequent risk of premature reaction.

The present invention provides a process for depositing a titanium oxide coating on hot flat glass comprising the steps of
(a) preparing a precursor gas mixture containing titanium tetrachloride and an organic oxygen containing compound as a source of oxygen for formation of the metal oxide,
(b) maintaining said precursor gas mixture at a temperature below the temperature at which titanium tetrachloride reacts to form the metal oxide while delivering the mixture to a coating chamber opening on to the hot glass,
(c) introducing the precursor gas mixture into the coating chamber whereby the mixture is heated to cause deposition of titanium oxide incorporating oxygen from the organic compound on to the hot glass surface.

Surprisingly, a wide range of oxygen-containing organic compounds may be used as the source of oxygen, without requiring the presence of water vapour or gaseous oxygen, including compounds normally considered reducing agents rather than oxidising agents, for example, alcohols. However, the preferred organic compounds are carbonyl compounds, especially esters; and particularly good results have been obtained using esters having an alkyl group with a β hydrogen. The alkyl group with a β hydrogen will normally contain two to ten carbon atoms.

It is preferred to use organic compounds, especially esters, containing from two to ten carbon atoms, since larger molecules tend to be less volatile and hence less convenient for use in the CVD process of the present invention.

Particularly preferred esters for use in the practice of the present invention include ethyl formate, ethyl acetate, ethyl propionate, isopropyl formate, isopropyl acetate, n-butyl acetate and t-butyl acetate.

The method of the present invention is generally practised in connection with the formation of a continuous glass ribbon substrate, for example during a float glass production process. However, the method of the present invention may be employed in coating other flat glass substrates either on-line or off-line.

The present invention involves the preparation of a precursor gas mixture which includes titanium tetrachloride and an organic oxygen containing compound; a carrier gas or diluent, for example, nitrogen, air or helium, will normally also be included in the gas mixture. Since thermal decomposition of the organic oxygen containing compound may initiate the metal oxide deposition reaction at a high rate, it is desirable that the precursor mixture be kept at a temperature below the thermal decomposition temperature of the organic oxygen compound to prevent prereaction of the gaseous mixture with formation of the metal oxide.

The gaseous mixture is maintained at a temperature below that at which it reacts to form the metal oxide, and delivered to a location near a flat glass substrate to be coated, the substrate being at a temperature above said reaction temperature (and above the decomposition temperature of the organic oxygen compound in the precursor gas mixture).

The precursor gas mixture is thereafter introduced into the vapour space directly over the substrate. The heat from the substrate raises the temperature of the precursor gas above the thermal decomposition temperature of the organic oxygen compound. The organic oxygen compound then decomposes with reaction with the metal tetrachloride producing a metal dioxide coating on the substrate.

The present invention permits the production of titanium oxide coatings deposited on the hot glass at a high deposition rate e.g. over 130Å/second and, in preferred embodiments, over 250Å per second.

The deposition rate is dependent upon the particular organic oxygen containing compound used, and the concentrations of both the organic oxygen containing compound and the metal chloride, as well as the temperature of the glass. For any particular combination of compounds, the optimum concentrations (and in particular the optimum proportion of organic oxygen containing compound to metal tetrachloride) and flow rates for rapid coating deposition may be determined by simple trial. However, it will be appreciated that the use of higher concentrations of reactants and high gas flow rates is likely to result in a less efficient overall conversion of the reactants into coating, so that the optimum condition for commercial operation may differ from the conditions which provide the highest deposition rates.

Preferably, the organic oxygen containing compound will be at a concentration by volume of about 0.5, especially 1, to 5 times the concentration by volume of the metal chloride. It will commonly be used in an amount of at least 30% by weight of the weight of metal chloride.

The method of the invention permits the production, at high rates, of titanium oxide coatings on hot flat glass substrates on line during the glass production process. The titanium oxide coatings may be produced with a high refractive index (at least 2.4) permitting the achievement of desired optical effects, especially when used in combination with other coating layers.

### BRIEF DESCRIPTION OF THE DRAWINGS

The above, as well as other advantages of the present invention, will become readily apparent to those skilled in the art from the following detailed description of preferred embodiments when considered in the light of the accompanying drawings in which:
**Fig 1** is a schematic view of a vertical section of an apparatus for practising a float glass process which includes gas distributors suitably positioned to enable the practising of the method of the present invention.
**Fig 2** is broken sectional view of an article coated according to this invention; and
**Fig 3** is an enlarged schematic end view of a gas distributor beam suitable for use in practising the present invention.
**Fig 4** is an enlarged schematic end view of an alternative gas distributor beam which may be used in practising the present invention.

### DESCRIPTION OF THE PREFERRED EMBODIMENT

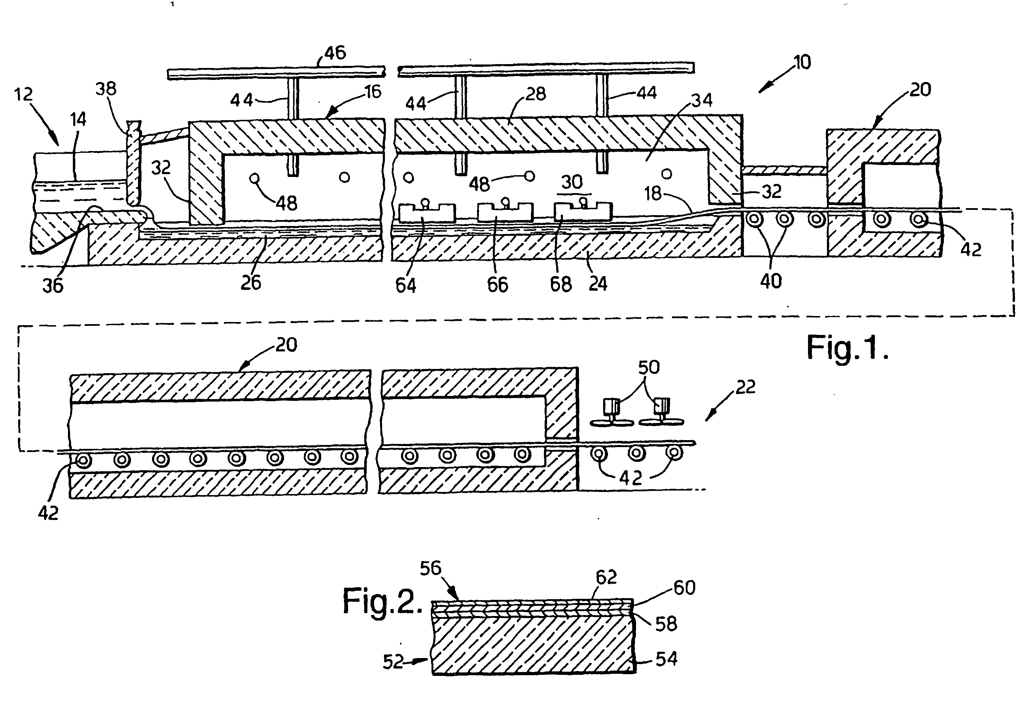

Referring now more particularly to the drawings, there is illustrated generally at 10 in Fig 1 a float glass installation utilized as a means for practising the method of the present invention. The float glass apparatus more particularly comprises a canal section 12 along which molten glass 14 is delivered from a melting furnace (not shown), to a float bath section 16 wherein a continuous glass ribbon 18 is formed in accordance with the well known float process. The glass ribbon 18 advances from the bath section 16 through an adjacent annealing lehr 20 and a cooling section 22. The continuous glass ribbon 18 serves as the substrate upon which the metal oxide coating is deposited in accordance with the present invention.

The float section 16 includes a bottom section 24 within which a bath of molten tin 26 is contained, a roof 28, opposite sidewalls 30, and end walls 32. The roof 28, side walls 30, and end walls 32 together define an enclosure 34 in which a non-oxidizing atmosphere is maintained to prevent oxidation of the molten tin.

Additionally, gas distributor beams 64, 66 and 68 are located in the bath section 16. The gas distributor beams 64 and 66 in the bath section may be employed to apply additional coatings onto the substrate prior to applying the titanium oxide coating by the method of the present invention. The additional coatings may include silicon and silica.

In operation, the molten glass 14 flows along the canal 36 beneath a regulating tweel 38 and downwardly onto the surface of the tin bath 26 in controlled amounts. On the tin bath the molten glass spreads laterally under the influences of gravity and surface tension, as well as certain mechanical influences, and it is advanced across the bath to form the ribbon 18. The ribbon is removed over lift out rolls 40 and is thereafter conveyed through the annealing lehr 20 and the cooling section 22 on aligned rolls 42. The application of the coating of the present invention may take place in the float bath section 16, or further along the production line, for example in the gap between the float bath and the annealing lehr, or in the annealing lehr.

A suitable non-oxidizing atmosphere, generally nitrogen or a mixture of nitrogen and hydrogen in which nitrogen predominates, is maintained in the bath enclosure 34 to prevent oxidation of the tin bath. The atmosphere gas is admitted through conduits 44 operably coupled to a distribution manifold 46. The non-oxidizing gas is introduced at a rate sufficient to compensate for normal losses and maintain a slight positive pressure, on the order of about 0.001 to about 0.01 atmosphere above ambient atmospheric pressure, so as to prevent infiltration of outside atmosphere. Heat for maintaining the desired temperature regime in the tin bath 26 and the enclosure 34 is provided by radiant heaters 48 within the enclosure. The atmosphere within the lehr 20 is typically atmospheric air, while the cooling section 22 is not enclosed and the glass ribbon is open to the ambient atmosphere. Ambient air may be directed against the glass ribbon as by fans 50 in the cooling section. Heaters (not shown) may also be provided within the annealing lehr for causing the temperature of the glass ribbon to be gradually reduced in accordance with a predetermined regime as it is conveyed therethrough.

Fig 1 illustrates the use of gas distributor beams 64, 66 and 68 positioned in the float bath 16 to deposit the various coatings on the glass ribbon substrate. The gas distributor beam is one form of reactor that can be employed in practising the process of the present invention.

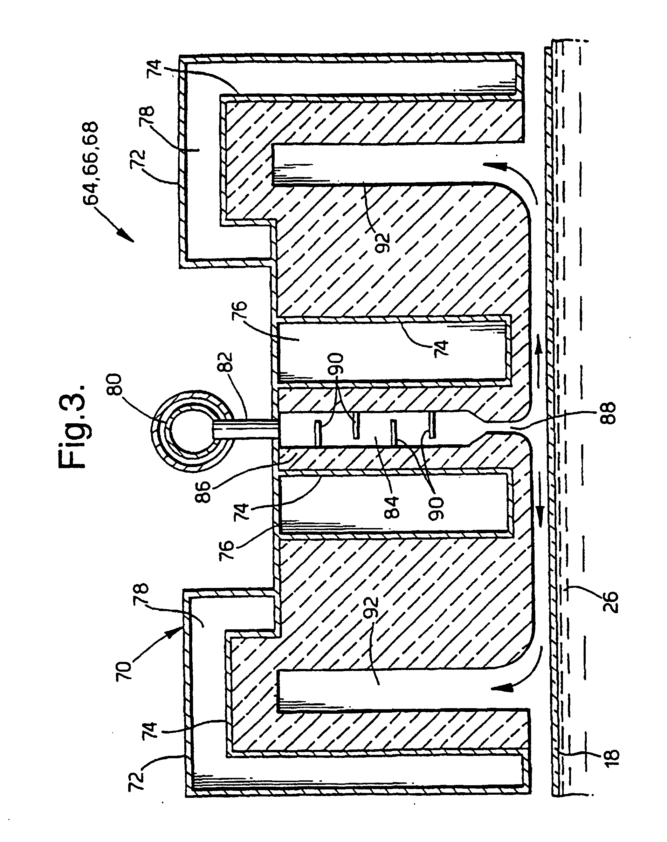

A convenient configuration for the distributor beams suitable for supplying the precursor materials in accordance with the invention is shown generally schematically at Fig 3. An inverted generally channel-shaped framework 70 formed by spaced inner and outer walls 72 and 74 defines enclosed cavities 76 and 78. A suitable heat exchange medium is circulated through the enclosed cavities 76, 78 in order to maintain the distributor beams at a desired temperature.

The precursor gas mixture is supplied through a fluid cooled supply conduit 80. The supply conduit 80 extends along the distributor beam and admits the gas through drop lines 82 spaced along the supply conduit. The supply conduit 80 leads to a delivery chamber 84 within a header 86 carried by the framework. Precursor gases admitted through the drop lines 82 are discharged from the delivery chamber 84 through a passageway 88 toward a coating chamber defining a vapour space opening on to the glass where they flow along the surface of the glass 18 in the direction of the arrows in Fig 3.

Baffle plates 90 may be provided within the delivery chamber 84 for equalizing the flow of precursor materials across the distributor beam to assure that the materials are discharged against the glass 18 in a smooth, laminar, uniform flow entirely across the distributor beam. Spent precursor materials are collected and removed through exhaust chambers 92 along the sides of the distributor beam.

Various forms of distributor beams used for chemical vapour deposition are suitable for the present method and are known in the prior art.

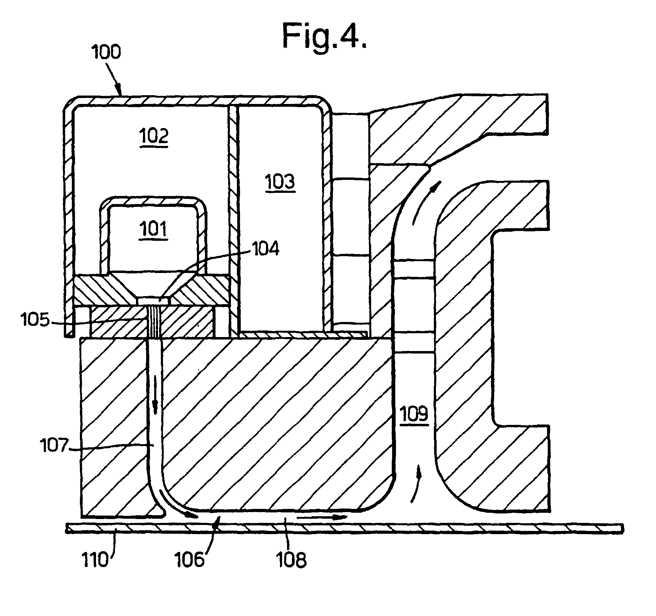

One such an alternative distributor beam configuration is illustrated schematically in Figure 4 of the drawings. Using this distributor, which is generally designated 100 (and more fully described in European patent EP 0 305 102B), the precursor gas mixture is introduced through a gas supply duct 101 where it is cooled by cooling fluid circulated through ducts 102 and 103. Gas supply duct 101 opens through an elongated aperture 104 into a gas flow restrictor 105.

Gas flow restrictor 105 is of the kind more fully described in UK patent specifications GB 1 507 996, and comprises a plurality of metal strips longitudinally crimped in the form of a sine wave and vertically mounted in abutting relationship with one another extending along the length of the distributor. Adjacent crimped metal strips are arranged "out of phase" to define a plurality of vertical channels between them. These vertical channels are of small cross-sectional area relative to the cross-sectional area of gas supply duct 101, so that the gas is released from the gas flow restrictor 105 at substantially constant pressure along the length of the distributor.

The coating gas is released from the gas flow restrictor into the inlet side 107 of a substantially U-shaped guide channel generally designated 106 comprising inlet leg 107, coating chamber 108 which opens onto the hot glass substrate 110 to be coated, and exhaust leg 109, whereby used coating gas is withdrawn from the glass. The rounded corners of the blocks defining the coating channel promote a uniform laminar flow of coating parallel to the glass surface across the glass surface to be coated.

The following examples (in which gas volumes are expressed under standard conditions, i.e. one atmosphere pressure and ambient temperature, unless other stated) are presented for the purpose of further illustrating and disclosing the present invention, and are not to be construed as a limitation on the invention:

### Examples 1 to 5

In this series of Examples, a bi-directional coating reactor of the type shown in **Fig 3** was employed in the laboratory to deposit a titanium oxide coating.

In Examples 1,2 and 3, the glass was heated on a conveyor furnace to simulate the coating reaction conditions of a float glass process in order to test the method of the present invention. The furnace utilized in-line rollers to convey a glass substrate through a heating zone prior to practising the method of the present invention. In Example 1, the glass substrate was float glass which had been initially provided with a silica coating. The silica coating was deposited on the float glass through a known chemical vapour deposition process utilizing a precursor of monosilane in an oxygen enriched atmosphere. The silica deposition forms no part of the present invention.

In accordance with the present invention, a titanium oxide coating was deposited on the silica coated substrate. The substrate was at a temperature of a 1170ºF/630ºC and the substrate line speed was at 300 inches/8 metres per minute.

To deposit the titanium oxide, a precursor gas mixture was developed comprising titanium tetrachloride, ethyl acetate, oxygen, and helium. Helium was included in the precursor mixture as a carrier for the reactants. The precursor mixture was prepared by simultaneously introducing all four gas streams through a manifold system. An in line static mixer was used to ensure a homogeneous precursor mixture. The volume percent composition of the precursor mixture was 0.7% titanium tetrachloride, 17.2% ethyl acetate, 7.2% oxygen, and 74.9% helium, with the flow rates for the components at the manifold being as shown in the accompanying Table 1.

The temperature of the precursor mixture was kept above 300ºF/150ºC in order to prevent the adduct reaction of titanium tetrachloride and ethyl acetate. The precursor temperature was also kept below the 950ºF - 1130ºF (510ºC - 610ºC) thermal decomposition temperature range of ethyl acetate in order to prevent the mixture from prereacting.

The precursor mixture was introduced into the reactor just above the moving substrate. The temperature at the precursor tower was 250ºF/120ºC. The temperature at the reactor face was 350ºF/175ºC. The higher substrate temperature initiated the thermal decomposition of the ethyl acetate which then resulted in the deposition of the titanium oxide.

The resulting coated glass was allowed to cool in air and the coating analysed. It was found to be titanium oxide with a carbon content of 2.5-3.5 atomic percent. The thickness of the titanium oxide coating was measured 490Å and the thickness and growth rate (150 Å per second) are shown in Table 1. The optical properties of the resulting product included an observed illuminant C transmittance (10º observer) of 62.3% and an observed Illuminant C reflectivity of 35.6%. The extinction coefficient was 0.008 at 550 nm, and the refractive index of the titanium oxide coating was 2.44.

In Examples 2 and 3 the coating procedure set out in Example 1 was repeated, except that in Example 2 ethyl formate was used as the organic source of oxygen, and in Example 3 isopropanol was used as the organic source of oxygen and uncoated glass (in place of the silicon oxide coated glass of Examples 1 and 2) was used as the substrate. The gas flow rates used and, in the case of Example 2, the thickness and growth rate of the titanium oxide coating produced are shown in Table 1. In Example 3, the isopropanol burned in the reactor leaving only particulate titanium oxide on the glass, the corresponding deposition rate therefore being quoted as 0Å/second.

The procedure for Examples 4 and 5 was as used in the previous Examples (the reactor temperature and the substrate being identical to Example 1), except that the substrate was static and not dynamic. The static sample was positioned under the reactor for 10 seconds. Under static conditions, the residence time of the substrate under the reactor is increased from the dynamic conditions by a factor of five.

In Example 4, methyl acetate was used as the organic source of oxygen, and in Example 5 t-butyl acetate was used; in each case a titanium oxide coating was produced. The gas flow rates, resulting titanium oxide coating thickness and coating growth rates are as shown in Table 1. The relatively slow growth rate achieved using methyl acetate is discussed hereinafter.

### Example 6

A float glass process was used in producing a continuous glass ribbon having a thickness of 0.125 inches/3 mm at a line speed of 434 inches/11 metres per minute. The glass temperature was at 1140ºF/615ºC at the desired point of application in the float bath section of a titanium oxide coating using a coating reactor similar to that shown in Figure 3. The temperature at the precursor tower was 400ºF/205ºC and the temperature at the reactor face was 500ºF/260ºC. Prior to practising the method of the present invention, a silica coating was deposited on the glass substrate in the float bath section at a thickness of about 339 Å. The same chemical vapour deposition process as described in Example 1 was used to deposit the silica coating. The silica deposition forms no part of the present invention.

The precursor gas mixture was developed comprising titanium tetrachloride and ethyl acetate in a helium carrier gas. Oxygen was not used in the precursor as result of earlier Examples indicated that the coating reaction was not sensitive to the oxygen concentration. The precursor mixture was prepared by simultaneously introducing the three components through a manifold system. The volume percent composition of the precursor mixture was 0.6% titanium tetrachloride, 1.8% ethyl acetate, and 97.5% helium. The flow rates for the components were 480.0 l/m of helium, 3.0 l/m of titanium tetrachloride, 9.2 l/m of ethyl acetate. The total flow rate for the precursor mixture was 492.2 l/m.

The resulting titanium oxide coating was 684 Å thick. The carbon content of the coating was less than 2 atomic percent. The growth rate of the coating was 309 Å per second.

### Example 7

The same procedure carried out Example 6 was utilized in this Example. The substrate comprised coatings of silicon and then silica over the glass substrate. The coatings were deposited by a known chemical vapour deposition process in the float bath section. The silicon coating was deposited by CVD from monosilane with a non-oxidizing carrier gas. The silica coating was then deposited onto the silicon coating through the use of the same procedure as described in Example 1.

The precursor for the titanium oxide coating included titanium tetrachloride and ethyl acetate in a helium carrier gas. The volume percent composition of the precursor was 0.5% titanium tetrachloride, 1.9% ethyl acetate, and 97.6% helium. The corresponding flow rates for the components were 480.0 l/m of helium, 2.4 l/m of titanium tetrachloride, 9.2 l/m of ethyl acetate. The total flow rate for the precursor mixture was 491.6 l/m.

The resulting coated article 52 is illustrated in Fig 2. The glass substrate 54 is depicted with a stack of multiple coatings 56. The coatings comprise a layer of silicon 58, a layer of silica 60, then a titanium oxide coating 62 on top of the article. The titanium oxide coating on the resulting article had a thickness of 836 Å. The optical properties of the resulting coating stack included an observed Illuminant C transmittance of 13.1% and an observed illuminant C reflectivity of 82.5%. The growth rate of the titanium oxide coating was 378 Å per second.

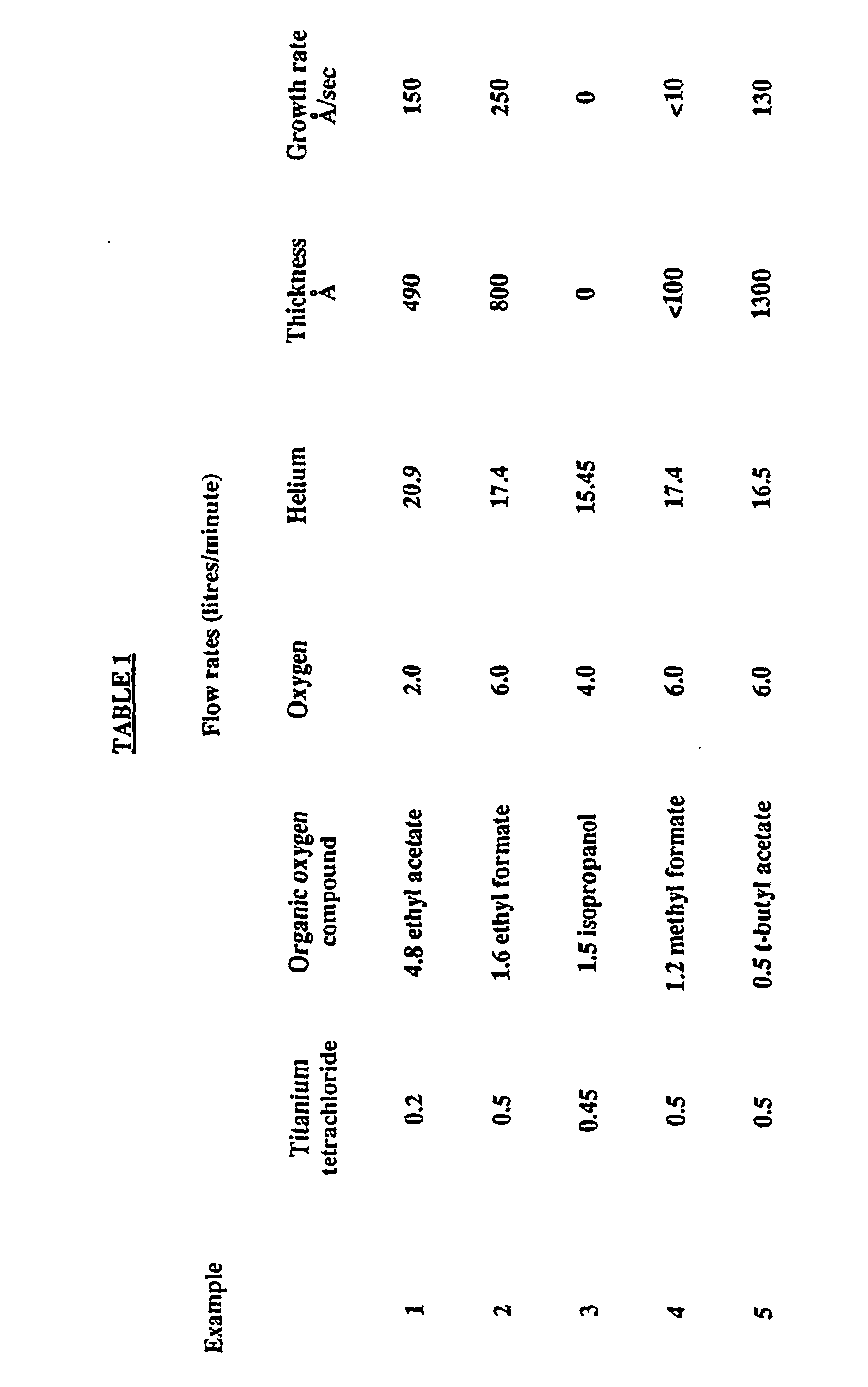

It will be appreciated that various changes and modifications can be made from the specific details of the invention as incorporated in the foregoing Examples without departing from the spirit and scope thereof as defined in the appended claims. In its essential details, the invention is a continuous chemical vapor deposition process for laying down titanium oxide coatings onto a glass substrate at high deposition rates through the use of titanium tetrachloride and an organic compound used as a source of oxygen in a preformed precursor gas mixture.

The metal tetrachlorides are preferred sources of the respective metals because of the availability and cost of the raw material.

It has been found, especially when depositing titanium oxide coatings from titanium tetrachloride, that, in order to form the metal oxide at the optimum deposition rates, it is desirable to use an organic oxygen containing compound which is an ester, particularly an ester in which the group derived from the alcohol is an alkyl group with a β hydrogen. Additionally, the decomposition temperature of the ester should not be greater than the reaction temperature of the coating precursor gas mixture at the desired point of application. Esters utilized in the precursor gas mixture that have a β hydrogen and appropriate decomposition temperatures will deposit the coatings at high deposition rates. The preferred group of esters used in practicing the present invention includes the group consisting of ethyl formate, ethyl acetate, ethyl propionate, isopropyl formate, isopropyl acetate, n-butyl acetate, and t-butyl acetate.

In general an ester decomposes in a continuous fashion over a given temperature range. In the present invention, the thermal decomposition temperature of the ester is defined as the temperature at which the unimolecular decomposition rate constant of the ester is 0.01/sec. The unimolecular decomposition rate constants of common esters such as ethyl acetate and t-butyl acetate are well known and can be found in the chemical literature. For ethyl acetate and t-butyl acetate, the thermal decomposition temperatures using the above definition are 935 and 650° Fahrenheit (500°C and 344°C), respectively. One skilled in the art will recognize that the choice of ester and specific deposition temperature employed will determine the optimum coating growth rate. Reaction temperatures below the defined thermal decomposition temperature, but within the decomposition range of the selected ester, will result in lower coating growth rates.

In accordance with the present invention, the alkyl group of an ester used in the coating precursor gas mixture may be a carbon compound having a range of 2-10 carbon atoms. The lower limit of the range is dictated by the β hydrogen requirement on the alkyl group. The upper limit is to avoid flammability and volatility issues that arise when the alkyl group contains more than ten carbon atoms.

In practising the method of the present invention, a manifold may be used to connect and regulate the individual gas streams to formulate the coating precursor gas mixture. A common delivery line may be used to deliver the precursor gas mixture from the manifold to the gas beam distributor. An in line static mixer may be used in the delivery line to ensure a homogeneous gas mixture. Additionally, the baffles in the gas distributor beam, illustrated in Fig. 3, or a gas flow restrictor as described with reference to Figure 4, may provide further mixing of the precursor gas at the reactor stage.

In many of the Examples, oxygen was included in the coating precursor gas mixture. However, the deposition rate of the metal oxide coating was not sensitive to the oxygen concentrations, and no oxygen gas was used in Examples 6 or 7 showing the inclusion of oxygen to be unnecessary

The concentration of the reactive components of the coating precursor gas mixture may be selected to obtain the optimum coating growth rate. The concentration of metal tetrachloride is generally 0.1 to 5.0 percent by volume in the precursor gas mixture. The concentration of metal tetrachloride is based upon the amount of metal needed to provide the desired coating thickness in the available residence time. Thus the metal tetrachloride concentration is adjusted according to process variables, such as the line speed of the ribbon in a float glass process.

The concentration of the organic oxygen compound in the coating precursor gas mixture is generally one to five times the concentration of the metal tetrachloride, being selected within this range based upon the deposition temperature. When using an ester, lower deposition temperatures will result in slower ester decomposition rates and therefore, will require greater concentrations of the ester to react with the metal tetrachloride. In Examples 6 and 7, the optimum concentration of the ethyl acetate in the precursor gas mixture is 1 to 3 times the concentration of the titanium tetrachloride. Concentrations above or below the optimum range will produce metal oxide coatings at lower coating growth rates.

The temperature of the precursor gas mixture is critical for control of the reaction, in particular to avoid undesirable pre-reaction or adduct formation resulting in formation of an involatile product in the precursor lines. In one preferred embodiment, especially applicable when using an ester, the temperature is maintained above 300°F/150ºC in the precursor gas lines. The precursor gas mixture is also preferably kept below the thermal decomposition temperature of the organic oxygen compound to prevent prereaction of the mixture.

The present inventive process utilizes the heat from the substrate to initialize the coating reaction. In on-line situations, such as the float glass process, the substrate is formed at extremely high temperatures. Therefore, the method of the present invention may be applied at a point in the float glass process where the substrate temperature is lowered but is still above the temperature at which the coating is formed (and preferably after the glass ribbon has substantially finished stretching i.e. below 1380°F/750°C). Offline applications of the present invention will require heating the substrate to a temperature above the decomposition temperature of the ester.

In practising the method of the present invention in the float glass process, the preferred point of application is in the float bath section. The temperature range at the point of application for the coating is usually about 1100°-1320°F/590°-715°C. The temperature is an important operating parameter because it influences the concentration of the organic compound utilized in the precursor gas mixture. The temperatures of the substrate in the float bath section are relatively stable and therefore exhibit little variation at the point of application. In examples 6 and 7 using ethyl acetate, the preferred substrate temperature range is 1100°-1250°F/590ºC-680ºC.

The heat from the substrate raises the temperature of the precursor gas mixture above the temperature required for coating formation (and when an ester is used as the organic compound above thermal decomposition temperature of the ester). The metal deposition reaction may be initiated by the decomposition of the organic oxygen compound. When titanium tetrachloride is used in combination with an ester having an alkyl group with a β hydrogen, the titanium oxide coating then forms on the substrate at decomposition rates that are ten times higher than known coating methods. In the on-line application with a float glass ribbon process, the ribbon passes under the gas distributor beam at a relatively fast rate. The metal oxide coating is deposited onto the float glass ribbon as the ribbon passes under the coater.

The inventors propose the following theory regarding the chemical reaction that may take place when using an ester having an alkyl group with a β hydrogen. However, the inventors do not wish to limit the invention to just this possible explanation, and therefore offer it merely as an aid to understanding the results of the present inventive process.

The inventors propose that as the ester decomposes, the carbon-hydrogen bond on one of the β hydrogens breaks and the hydrogen transfers to the carbonyl group eliminating an alkene and forming a caboxylic acid. The hydrolysis reaction simultaneously takes place between the carboxylic acid and the metal tetrachloride leading to the formation of the metal oxide coating on the substrate.

In general, the resulting article produced in accordance with the present invention comprises a substrate having a titanium oxide coating. The coating may be applied directly to the substrate or as a layer in a plurality of coatings on a substrate. The rate of deposition of the metal oxide coating is effected by the decomposition rate of the organic oxygen compound. At constant reaction temperatures different organic oxygen compounds will provide different coating growth rates because of the difference in the decomposition temperatures. Therefore, the desired metal oxide coating growth rate for a given system is selected by matching a specific organic oxygen compound to the precursor gas mixture temperature and the substrate temperature at the point of application.

The deposition rate of the titanium oxide coating in the present invention may be ten times greater than rates in known deposition methods. The present inventive process permits deposition rates over 130Å per second with some deposition rates measured well over 300Å per second. The higher deposition rates for titanium oxide yield a coating with a refractive index greater than 2.4.

A further advantage of the invention, in addition to the high coating rates achievable, is that it employes low cost metal precursor compounds and, especially when the precursor gas mixture is directed over the substrate under the preferred laminar flow conditions, it enables high conversion efficiency (of the metal tetrachloride) to be achieved.

In the present invention, the resulting oxide coating contains little residual carbon from the decomposition of the organic oxygen compound, especially when an ester is used. Carbon is an undesirable byproduct of the coating reaction because high levels of carbon in deposition coatings create absorption problems with the coating. The concern in using an organic oxygen compound in the coating precursor gas mixture is that decomposition will result in levels of carbon that adversely affect the absorption properties of the finished glass. The carbon content in the coatings produced from the method of the present invention showed less than four atomic percent of carbon where measured. This low level of carbon will not significantly affect absorption properties of the coating.

It is to be understood that the forms of the invention herewith shown and described are to be taken as illustrative embodiments only of the same, and that various changes in the shape, size and arrangement of parts, as well as various procedural changes, may be resorted to without departing from the invention, as defined in the claims.

## Claims

1. A process for depositing a titanium oxide coating on hot flat glass comprising the steps of:
(a) preparing a precursor gas mixture containing tetrachloride and an organic oxygen containing compound as a source of oxygen for formation of the metal oxide,
(b) maintaining said precursor gas mixture at a temperature below the temperature at which titanium chloride reacts to form the metal oxide while delivering the mixture to a coating chamber opening on to the hot glass,
(c) introducing the precursor gas mixture into the coating chamber whereby the mixture is heated to cause deposition of titanium oxide incorporating oxygen from the organic compound on the hot glass surface.

2. A process for depositing a titanium oxide coating on hot flat glass as claimed in claim 1, wherein said organic oxygen containing compound is an ester containing from two to ten carbon atoms, and wherein the ester is at a concentration by volume of 0.5 to 5 times the concentration by volume of titanium tetrachloride.

3. A process for depositing a titanium oxide coating on hot flat glass as claimed in claim 2, wherein said ester is an ester having an alkyl group with a β hydrogen.

4. A process for depositing a titanium oxide coating on hot flat glass as claimed in any of the preceding claims, wherein said ester is selected from the group consisting of ethyl formate, ethyl acetate, ethyl propionate, isopropyl formate, isopropyl acetate, n-butyl acetate, and t-butyl acetate.

5. A process for depositing a titanium oxide coating on hot flat glass as claimed in any of the preceding claims, wherein the substrate is a float glass ribbon having a temperature in the range of about 1100°-1320°F/590ºC-715ºC.

6. A process for depositing a titanium oxide coating as claimed in any of the preceding claims, wherein the titanium tetrachloride in the precursor gas mixture is at a concentration of about 0.1-5.0% by volume.

7. A process for depositing a titanium oxide coating on hot flat glass as claimed in any of the preceding claims, wherein the organic oxygen containing compound in the precursor gas mixture is at a concentration of about 1 to 5 times the concentration of the titanium tetrachloride.

8. A process for depositing a titanium oxide coating on hot flat glass as claimed in any of claims 2 to 7, wherein said ester is ethyl acetate and said hot flat glass is a float glass ribbon.

9. A process for depositing a titanium oxide coating on hot flat glass as claimed in any of the preceding claims wherein the hot flat glass substrate has a silica coating thereon, and said titanium oxide coating is deposited over the silica coating.

10. A process for depositing a titanium oxide coating on hot flat glass as claimed in any of the claims preceding, wherein the hot flat glass substrate has a silica coating over a silicon coating, and said titanium oxide coating is deposited over the silica coating.

11. A process for depositing a titanium oxide coating on a substrate on hot flat glass as claimed in any of the preceding claims, wherein said titanium oxide coating has a refractive index greater than 2.4.

12. A process for depositing a titanium oxide coating on hot flat glass as claimed in any of the preceding claims, wherein the titanium oxide coating has a residual carbon content less than 4 atomic percent.

13. A process for depositing a titanium oxide coating on hot flat glass as claimed in any of the preceding claims, wherein said precursor gas mixture includes helium as a carrier gas.

14. A process for depositing a titanium oxide coating on hot flat glass as claimed in any of claims 2 to 13, wherein the ester has an alkyl group having 2-10 carbon atoms.

15. A process for depositing a titanium oxide coating on hot flat glass as claimed in any of the preceding claims, wherein the titanium oxide film is deposited at a rate of at least 130Å per second.

16. A process for depositing a titanium oxide coating on a substrate at high deposition rates, being a process as claimed in any of the preceding claims, comprising the steps of:
(a) preparing a precursor gas mixture containing titanium tetrachloride and an ester, said ester having an alkyl group with a β hydrogen;
(b) delivering said precursor gas mixture at a temperature below the thermal decomposition temperature of said ester to a location near a substrate to be coated, said substrate being at a temperature above the thermal decomposition temperature of said ester; and
(c) introducing said precursor gas mixture into a vapour space above said substrate wherein said ester thermally decomposes and thereby initiates a reaction with said titanium tetrachloride to produce a titanium oxide coating on said substrate.

17. A process as claimed in claim 16 wherein the substrate is a float glass ribbon.

18. A process as claimed in claim 16 or claim 17 wherein the precursor gas mixture is delivered to the substrate at a location where the substrate temperature is in the range 1100-1320°F (590 °C - 715 °C).

19. A process for depositing a titanium oxide coating on a substrate at high deposition rates, comprising the steps of:
(a) preparing a precursor gas mixture containing titanium tetrachloride and an ester, said ester containing from two to ten carbon atoms and having an alkyl group with a β hydrogen;
(b) delivering said precursor gas mixture at a temperature below the thermal decomposition temperature of said ester to a location near a substrate to be coated, said substrate being at a temperature above the thermal decomposition temperature of said ester; and
(c) introducing said precursor gas mixture into a vapour space above said substrate wherein said ester thermally decomposes and thereby initiates a reaction with said titanium tetrachloride to produce a titanium oxide coating on said substrate.

20. A process as claimed in claim 19 wherein the substrate is a float glass ribbon.

21. A process as claimed in claim 19 or claim 20 wherein the precursor gas mixture is delivered to the substrate at a location where the substrate temperature is in the range 1100-1320°F (590 °C - 715 °C).

22. A process for depositing a titanium oxide coating on hot flat glass as claimed in any of the preceding claims wherein the precursor gas mixture is caused to flow over the glass surface to be coated under laminar flow conditions.

23. Use of an ester as a source of oxygen for formation of a metal oxide in a process for depositing a titanium oxide coating on hot flat glass comprising the steps of:
(a) preparing a precursor gas mixture containing titanium tetrachloride and a source of oxygen,
(b) maintaining said precursor gas mixture at a temperature below the temperature at which titanium chloride reacts to form the metal oxide while delivering the mixture to a coating chamber opening on to the hot glass,
(c) introducing the precursor gas mixture into the coating chamber whereby the mixture is heated to cause deposition of titanium oxide on the hot glass surface.

## Patentansprüche

1. Verfahren zum Aufbringen einer Titanoxidbeschichtung auf heißem Flachglas, das die Stufen
(a) Herstellen eines Vorläufergasgemischs, das Titantetrachlorid und eine Sauerstoff enthaltende organische Verbindung als Sauerstoffquelle für die Bildung des Metalloxids enthält,
(b) Halten des Vorläufergasgemischs auf einer Temperatur von unterhalb der Temperatur, bei welcher das Titantetrachlorid unter Bildung von Metalloxid reagiert, während das Gemisch in eine Beschichtungskammer geleitet wird, die zum heißen Glas hin offen ist, und
(c) Leiten des Vorläufergasgemischs in die Beschichtungskammer, wodurch das Gemisch erhitzt und Titanoxid, das Sauerstoff aus der organischen Verbindung enthält, auf der heißen Glasoberfläche abgeschieden wird,
umfaßt.

2. Verfahren zum Aufbringen einer Titanoxidbeschichtung auf heißem Flachglas nach Anspruch 1, wobei die Sauerstoff enthaltende organische Verbindung ein Ester ist, der zwei bis zehn Kohlenstoffatome enthält und mit einer auf das Volumen bezogenen Konzentration vom 0,5- bis 5fachen der auf das Volumen bezogenen Konzentration des Titantetrachlorids vorliegt.

3. Verfahren zum Aufbringen einer Titanoxidbeschichtung auf heißem Flachglas nach Anspruch 2, wobei der Ester ein Ester mit einer Alkylgruppe mit einem β-Wasserstoff ist.

4. Verfahren zum Aufbringen einer Titanoxidbeschichtung auf heißem Flachglas nach einem der vorhergehenden Ansprüche, wobei der Ester aus der Gruppe ausgewählt ist, die aus Ethylformiat, Ethylacetat, Ethylpropionat, Isopropylformiat, Isopropylacetat, n-Butylacetat und *tert*.-Butylacetat besteht.

5. Verfahren zum Aufbringen einer Titanoxidbeschichtung auf heißem Flachglas nach einem der vorhergehenden Ansprüche, wobei das Substrat ein Floatglasband mit einer Temperatur im Bereich von etwa 1 100 bis 1 320 °F/590 bis 715 °C ist.

6. Verfahren zum Aufbringen einer Titanoxidbeschichtung nach einem der vorhergehenden Ansprüche, wobei das Titantetrachlorid im Vorläufergasgemisch mit einer Konzentration von etwa 0,1 bis 5,0 Vol.-% vorliegt.

7. Verfahren zum Aufbringen einer Titanoxidbeschichtung auf heißem Flachglas nach einem der vorhergehenden Ansprüche, wobei die Sauerstoff enthaltende organische Verbindung im Vorläufergasgemisch mit einer Konzentration von etwa dem 1- bis 5fachen der Konzentration des Titantetrachlorids vorliegt.

8. Verfahren zum Aufbringen einer Titanoxidbeschichtung auf heißem Flachglas nach einem der Ansprüche 2 bis 7, wobei der Ester Ethylacetat und das heiße Flachglas ein Floatglasband ist.

9. Verfahren zum Aufbringen einer Titanoxidbeschichtung auf heißem Flachglas nach einem der vorhergehenden Ansprüche, wobei das heiße Flachglassubstrat eine Siliciumdioxidbeschichtung darauf aufweist und die Titanoxidbeschichtung auf der Siliciumdioxidbeschichtung aufgebracht wird.

10. Verfahren zum Aufbringen einer Titanoxidbeschichtung auf heißem Flachglas nach einem der vorhergehenden Ansprüche, wobei das heiße Flachglassubstrat eine Siliciumdioxidbeschichtung auf einer Siliciumbeschichtung aufweist und die Titanoxidbeschichtung auf der Siliciumdioxidbeschichtung aufgebracht wird.

11. Verfahren zum Aufbringen einer Titanoxidbeschichtung auf ein Substrat auf heißem Flachglas nach einem der vorhergehenden Ansprüche, wobei der Brechungsindex der Titanoxidbeschichtung mehr als 2,4 beträgt.

12. Verfahren zum Aufbringen einer Titanoxidbeschichtung auf heißem Flachglas nach einem der vorhergehenden Ansprüche, wobei der Restkohlenstoffgehalt der Titanoxidbeschichtung weniger als 4 Atomprozent beträgt.

13. Verfahren zum Aufbringen einer Titanoxidbeschichtung auf heißem Flachglas nach einem der vorhergehenden Ansprüche, wobei das Vorläufergasgemisch Helium als Trägergas enthält.

14. Verfahren zum Aufbringen einer Titanoxidbeschichtung auf heißem Flachglas nach einem der Ansprüche 2 bis 13, wobei der Ester eine Alkylgruppe 2 bis 10 Kohlenstoffatomen aufweist.

15. Verfahren zum Aufbringen einer Titanoxidbeschichtung auf heißem Flachglas nach einem der vorhergehenden Ansprüche, wobei die Titanoxidbeschichtung mit einer Geschwindigkeit von mindestens 130 Å pro Sekunde aufgebracht wird.

16. Verfahren zum Aufbringen einer Titanoxidbeschichtung auf ein Substrat mit einer hohen Abscheidungsgeschwindigkeit, das ein Verfahren nach einem der vorhergehenden Ansprüche ist und die Stufen
(a) Herstellen eines Vorläufergasgemischs, das Titantetrachlorid und einen Ester enthält, wobei der Ester eine Alkylgruppe mit einem β-Wasserstoff aufweist,
(b) Leiten des Vorläufergasgemischs mit einer Temperatur von unterhalb der thermischen Zersetzungstemperatur des Esters an eine Stelle in der Nähe des zu beschichtenden Substrats, wobei das Substrat eine Temperatur von oberhalb der thermischen Zersetzungstemperatur dieses Esters besitzt, und
(c) Leiten des Vorläufergasgemischs in einen Dampfraum über dem Substrat, worin der Ester thermisch zersetzt und dadurch eine Reaktion mit dem Titantetrachiorid ausgelöst wird, wodurch sich auf diesem Substrat eine Titanoxidbeschichtung bildet,
umfaßt.

17. Verfahren nach Anspruch 16, wobei das Substrat ein Floatglasband ist.

18. Verfahren nach Anspruch 16 oder 17, wobei das Vorläufergasgemisch auf das Substrat an einer Stelle geleitet wird, wo sich die Substrattemperatur im Bereich von 1 100 bis 1 320 °F(590 bis 715 °C) befindet.

19. Verfahren zum Aufbringen einer Titanoxidbeschichtung auf ein Substrat mit hoher Abscheidungsgeschwindigkeit, das die Stufen
(a) Herstellen eines Vorläufergasgemischs, das Titantetrachlorid und einen Ester enthält, wobei der Ester zwei bis zehn Kohlenstoffatome enthält und eine Alkylgruppe mit einem β-Wasserstoff aufweist,
(b) Leiten des Vorläufergasgemischs mit einer Temperatur von unterhalb der thermischen Zersetzungstemperatur des Esters zu einer Stelle in der Nähe des zu beschichtenden Substrats, wobei das Substrat eine Temperatur von oberhalb der thermischen Zersetzungstemperatur dieses Esters besitzt, und
(c) Leiten des Vorläufergasgemischs in einen Dampfraum über dem Substrat, worin sich der Ester thermisch zersetzt und dadurch eine Reaktion mit dem Titantetrachlorid ausgelöst wird, wodurch sich auf dem Substrat eine Titanoxidbeschichtung bildet,
umfaßt.

20. Verfahren nach Anspruch 19, wobei das Substrat ein Floatglasband ist.

21. Verfahren nach Anspruch 19 oder 20, wobei das Vorläufergasgemisch auf das Substrat an einer Stelle geleitet wird, wo sich die Substrattemperatur im Bereich von 1 100 bis 1 320 °F (590 bis 715 °C) befindet.

22. Verfahren zum Aufbringen einer Titanoxidbeschichtung auf heißem Flachglas nach einem der vorhergehenden Ansprüche, wobei das Vorläufergasgemisch über die zu beschichtende Glasoberfläche unter den Bedingungen einer laminaren Strömung strömen gelassen wird.

23. Verwendung eines Esters als Sauerstoffquelle für die Bildung eines Metalloxids in einem Verfahren zum Aufbringen einer Titanoxidbeschichtung auf heißem Flachglas, das die Stufen
(a) Herstellen eines Vorläufergasgemischs, das Titantetrachlorid und eine Sauerstoffquelle enthält,
(b) Halten des Vorläufergasgemischs auf einer Temperatur von unterhalb der Temperatur, bei welcher das Titanchlorid unter Bildung des Metalloxids reagiert, während das Gemisch zur Öffnung einer Beschichtungskammer auf das heiße Glas geleitet wird, und
(c) Leiten des Vorläufergasgemischs in die Beschichtungskammer, wodurch das Gemisch erhitzt und die Abscheidung von Titanoxid auf der heißen Glasoberfläche bewirkt wird,
umfaßt.

## Revendications

1. Procédé pour déposer un revêtement d'oxyde de titane sur du verre plat chaud, comprenant les étapes consistant :
(a) à préparer un mélange gazeux précurseur contenant du tétrachlorure de titane et un composé organique contenant de l'oxygène comme source d'oxygène pour la formation de l'oxyde métallique,
(b) à maintenir ledit mélange gazeux précurseur à une température inférieure à la température à laquelle le chlorure de titane réagit pour former l'oxyde métallique tout en délivrant le mélange à une chambre de revêtement s'ouvrant sur le verre chaud,
(c) à introduire le mélange gazeux précurseur dans la chambre de revêtement, ce qui provoque le chauffage du mélange avec pour effet le dépôt d'oxyde de titane renfermant de l'oxygène à partir du composé organique sur la surface du verre chaud.

2. Procédé pour déposer un revêtement d'oxyde de titane sur du verre plat chaud suivant la revendication 1, dans lequel le composé organique contenant de l'oxygène est un ester contenant 2 à 10 atomes de carbone, et dans lequel l'ester est à une concentration en volume de 0,5 à 5 fois la concentration en volume du tétrachlorure de titane.

3. Procédé pour déposer un revêtement d'oxyde de titane sur du verre plat chaud, suivant la revendication 2, dans lequel l'ester est un ester ayant un groupe alkyle avec un atome d'hydrogène β.

4. Procédé pour déposer un revêtement d'oxyde de titane sur du verre plat chaud, suivant l'une quelconque des revendications précédentes, dans lequel l'ester est choisi dans le groupe consistant en le formiate d'éthyle, l'acétate d'éthyle, le propionate d'éthyle, le formiate d'isopropyle, l'acétate d'isopropyle, l'acétate de n-butyle et l'acétate de tertiobutyle.

5. Procédé pour déposer un revêtement d'oxyde de titane sur du verre plat chaud suivant l'une quelconque des revendications précédentes, dans lequel le substrat est un ruban de verre flotté ayant une température comprise dans l'intervalle d'environ 1100°- 1320°F/590°C - 715°C.

6. Procédé pour déposer un revêtement d'oxyde de titane suivant l'une quelconque des revendications précédentes, dans lequel le tétrachlorure de titane dans le mélange gazeux précurseur est à une concentration d'environ 0,1 à 5,0 % en volume.

7. Procédé pour déposer un revêtement d'oxyde de titane sur du verre plat chaud suivant l'une quelconque des revendications précédentes, dans lequel le composé organique contenant de l'oxygène dans le mélange gazeux précurseur est à une concentration d'environ 1 à 5 fois la concentration du tétrachlorure de titane.

8. Procédé pour déposer un revêtement d'oxyde de titane sur du verre plat chaud suivant l'une quelconque des revendications 2 à 7, dans lequel l'ester est l'acétate d'éthyle et le verre plat chaud est un ruban de verre flotté.

9. Procédé pour déposer un revêtement d'oxyde de titane sur du verre plat chaud suivant l'une quelconque des revendications précédentes, dans lequel le substrat consistant en verre plat chaud porte un revêtement de silice, et ledit revêtement d'oxyde de titane est déposé sur le revêtement de silice.

10. Procédé pour déposer un revêtement d'oxyde de titane sur du verre plat chaud suivant l'une quelconque des revendications précédentes, dans lequel le substrat consistant en verre plat chaud porte un revêtement de silice sur un revêtement de silicium, et ledit revêtement d'oxyde de titane est déposé sur le revêtement de silice.

11. Procédé pour déposer un revêtement d'oxyde de titane sur un substrat consistant en verre plat chaud suivant l'une quelconque des revendications précédentes, dans lequel ledit revêtement d'oxyde de titane a un indice de réfraction supérieur à 2,4.

12. Procédé pour déposer un revêtement d'oxyde de titane sur du verre plat chaud suivant l'une quelconque des revendications précédentes, dans lequel le revêtement d'oxyde de titane a une teneur en carbone résiduelle inférieure à 4 % atomique.

13. Procédé pour déposer un revêtement d'oxyde de titane sur du verre plat chaud suivant l'une quelconque des revendications précédentes, dans lequel le mélange gazeux précurseur comprend de l'hélium comme véhicule gazeux.

14. Procédé pour déposer un revêtement d'oxyde de titane sur du verre plat chaud suivant l'une quelconque des revendications 2 à 13, dans lequel l'ester possède un groupe alkyle ayant 2 à 10 atomes de carbone.

15. Procédé pour déposer un revêtement d'oxyde de titane sur du verre plat chaud suivant l'une quelconque des revendications précédentes, dans lequel le film d'oxyde de titane est déposé à une vitesse d'au moins 130 Å par seconde.

16. Procédé pour déposer un revêtement d'oxyde de titane sur un substrat à de grandes vitesses de dépôt, consistant en un procédé suivant l'une quelconque des revendications précédentes, comprenant les étapes consistant :
(a) à préparer un mélange gazeux précurseur contenant du tétrachlorure de titane et un ester, ledit ester ayant un groupe alkyle avec un atome d'hydrogène β ;
(b) à délivrer ledit mélange gazeux précurseur à une température inférieure à la température de décomposition thermique dudit ester à un emplacement proche d'un substrat à revêtir, ledit substrat étant à une température supérieure à la température de décomposition thermique dudit ester ;
(c) à introduire ledit mélange gazeux précurseur dans un espace de vapeur au-dessus dudit substrat, dans lequel ledit ester subit une décomposition thermique et déclenche ainsi une réaction avec ledit tétrachlorure de titane pour produire un revêtement d'oxyde de titane sur ledit substrat.

17. Procédé suivant la revendication 16, dans lequel le substrat est un ruban de verre flotté.

18. Procédé suivant la revendication 16 ou la revendication 17, dans lequel le mélange gazeux précurseur est délivré au substrat à un emplacement où la température du substrat est comprise dans l'intervalle de 1100 à 1320°F (590°C à 715°C).

19. Procédé pour déposer un revêtement d'oxyde de titane sur un substrat à de grandes vitesses de dépôt, comprenant les étapes consistant :
(a) à préparer un mélange gazeux précurseur contenant du tétrachlorure de titane et un ester, ledit ester contenant 2 à 10 atomes de carbone et ayant un groupe alkyle avec un atome d'hydrogène β ;
(b) à délivrer ledit mélange gazeux précurseur à une température inférieure à la température de décomposition thermique dudit ester à un emplacement proche d'un substrat à revêtir, ledit substrat étant à une température supérieure à la température de décomposition thermique dudit ester ; et
(c) à introduire ledit mélange gazeux précurseur dans un espace de vapeur au-dessus dudit substrat, dans lequel ledit ester subit une décomposition thermique et déclenche ainsi une réaction avec ledit tétrachlorure de titane pour produire un revêtement d'oxyde de titane sur ledit substrat.

20. Procédé suivant la revendication 19, dans lequel le substrat est un ruban de verre flotté.

21. Procédé suivant la revendication 19 ou la revendication 20, dans lequel le mélange gazeux précurseur est délivré au substrat à un emplacement où la température du substrat est comprise dans l'intervalle de 1100 à 1320°F (590°C à 715°C).

22. Procédé pour déposer un revêtement d'oxyde de titane sur du verre plat chaud suivant l'une quelconque des revendications précédentes, dans lequel le mélange gazeux précurseur est amené à s'écouler sur la surface du verre à revêtir dans des conditions d'écoulement laminaire.

23. Utilisation d'un ester comme source d'oxygène pour la formation d'un oxyde métallique dans un procédé pour déposer un revêtement d'oxyde de titane sur du verre plat chaud, comprenant les étapes consistant :
(a) à préparer un mélange gazeux précurseur contenant du tétrachlorure de titane et une source d'oxygène,
(b) à maintenir ledit mélange gazeux précurseur à une température inférieure à la température à laquelle le chlorure de titane réagit pour former l'oxyde métallique tout en délivrant le mélange à une chambre de revêtement s'ouvrant sur le verre chaud,
(c) à introduire le mélange gazeux précurseur dans la chambre de revêtement, ce qui fait que le mélange est chauffé pour provoquer le dépôt d'oxyde de titane sur la surface du verre chaud.
